# EUROPEAN PATENT APPLICATION

(11) **EP 4 343 840 A2**
(43) Date of publication of application: **27.03.2024**
(21) Application number: 23192991.0
(22) Date of filing: 23.08.2023
(51) Int. Cl.: H01L 25/065

(54) **SEMICONDUCTOR PACKAGE**

(30) Priority: 15.09.2022 KR 20220116572
(71) Applicant: Samsung Electronics Co., Ltd., Suwon-si, Gyeonggi-do 16677 (KR)
(72) Inventor: JANG, Ae-Nee, 16677 Suwon-si (KR); BAEK, Seungduk, 16677 Suwon-si (KR)
(74) Representative: Marks & Clerk LLP

(57) **Abstract**

A semiconductor package includes a first semiconductor chip on a substrate and including a first semiconductor substrate and a first test pattern on a first surface of the first semiconductor substrate; and a second semiconductor chip on the first semiconductor chip and including a second semiconductor substrate and a second test pattern on a second surface of the second semiconductor substrate. The first and second semiconductor chips being bonded to allow the first test pattern to face the second test pattern. The first test pattern includes a first in-pad, first connection pads, and a first out-pad. The second test pattern includes a second in-pad bonded to the first in-pad, a second out-pad bonded to the first out-pad, and second connection pads bonded to the first connection pads. The first and second connection pads are connected in series to alternately connect with each other and form a series wiring pattern, so that each first connection pad connects to another first connection pad in one direction along the series wiring pattern and to a second connection pad in an opposite direction along the series wiring pattern.

## Description

Aspects of the present inventive concept relate to a semiconductor package, and more particularly, to a stacked semiconductor package.

### BACKGROUND

In the semiconductor industry, high capacity, thinness, and small size of semiconductor packages and electronic products using the same have been demanded and thus various package techniques have been suggested. One approach of the various package techniques is a packaging technique which vertically stacks a plurality of semiconductor chips to achieve a high density chip stacking. This packaging technique has an advantage of being capable of integrating semiconductor chips having various functions on a smaller area than a conventional package consisting of one semiconductor chip.

A semiconductor package is provided to implement an integrated circuit chip to be suitable for use in electronic products. A semiconductor package is typically configured such that a semiconductor chip is mounted on a printed circuit board and bonding wires or bumps are used to electrically connect the semiconductor chip to the printed circuit board. With the development of the electronics industry, various research has been conducted to improve reliability and durability of semiconductor packages.

### SUMMARY

Some embodiments of the present inventive concepts provide a semiconductor package capable of easily testing for structural defects.

The benefits of the present inventive concepts is not limited to those mentioned above, and other benefits which have not been mentioned above will be clearly understood to those skilled in the art from the following description.

According to some embodiments of the present inventive concepts, a semiconductor package may comprise: a substrate; a first semiconductor chip on the substrate, the first semiconductor chip including a first semiconductor substrate and a first test pattern on a first surface of the first semiconductor substrate; and a second semiconductor chip on the first semiconductor chip, the second semiconductor chip including a second semiconductor substrate and a second test pattern on a second surface of the second semiconductor substrate. The second semiconductor chip and the first semiconductor chip may be bonded to each other to allow the first test pattern to face the second test pattern. The first test pattern may include a first in-pad, first connection pads, and a first out-pad that are arranged in a plurality of rows and columns. The second test pattern may include a second in-pad bonded to the first in-pad, a second out-pad bonded to the first out-pad, and second connection pads bonded to the first connection pads. The first connection pads and the second connection pads may be connected in series to alternately connect with each other and form a series wiring pattern, so that each first connection pad connects to another first connection pad in one direction along the series wiring pattern and to a second connection pad in an opposite direction along the series wiring pattern.

According to some embodiments of the present inventive concepts, a semiconductor package may comprise: a substrate; a first semiconductor chip on the substrate; and a second semiconductor chip on the first semiconductor chip. The first semiconductor chip may include: a first semiconductor substrate; a first circuit layer on a bottom surface of the first semiconductor substrate; first test pads on a top surface of the first semiconductor substrate and adjacent to a corner of the first semiconductor substrate; and first through vias that vertically penetrate the first semiconductor substrate, the first through vias being electrically connected to the first circuit layer. The second semiconductor chip may include: a second semiconductor substrate; and a second circuit layer on a bottom surface of the second semiconductor substrate. The second circuit layer may include second test pads adjacent to a corner of the second semiconductor substrate. Each of the second test pads may be bonded to and simultaneously overlap, from a plan view, two neighboring ones of the first test pads. The first and second test pads may constitute a series circuit.

According to some embodiments of the present inventive concepts, a semiconductor package may comprise: a substrate; semiconductor chips stacked on the substrate; and a molding layer on the substrate, the molding layer surrounding the semiconductor chips. Each of the semiconductor chips may include: a semiconductor substrate having a first surface and a second surface that are opposite to each other; a semiconductor element on the first surface of the semiconductor substrate; first signal pads and first test pads on the first surface of the semiconductor substrate; second signal pads and second test pads on the second surface of the semiconductor substrate; first vias that vertically penetrate the semiconductor substrate, the first vias connecting the first signal pads to the second signal pads; and second vias that vertically penetrate the semiconductor substrate, the second vias connecting respective ones of the first test pads to ones of the second test pads. Two neighboring ones of the semiconductor chips may be bonded to each other. The first signal pads and the second signal pads may contact each other. The first test pads and the second test pads may contact each other. The first and second signal pads may be on a central region of the semiconductor substrate. The first and second test pads may be on a test region between the central region and a corner of the semiconductor substrate. The first and second test pads may be connected in series and alternately connected with each other.

At least some of the above and other features of the invention are set out in the claims.

### BRIEF DESCRIPTION OF THE DRAWINGS

FIG. 1 illustrates a cross-sectional view showing a semiconductor package according to some embodiments of the present inventive concepts.
FIG. 2 illustrates a cross-sectional view showing a bonding between semiconductor chips.
FIG. 3 illustrates a plan view showing a semiconductor chip of a semiconductor package according to some embodiments of the present inventive concepts.
FIGS. 4 to 6 illustrate diagrams showing planar shapes of test pads.
FIGS. 7 to 12 illustrate plan views showing an arrangement and connection relation between test pads.
FIG. 13 illustrates a cross-sectional view showing a bonding between semiconductor chips.
FIGS. 14 to 19 illustrate plan views showing an arrangement and connection relation between test pads.
FIGS. 20 to 22 illustrate cross-sectional views showing a method of testing a bonding between semiconductor chips in a semiconductor package according to some embodiments of the present inventive concepts.
FIG. 23 illustrates a cross-sectional view showing a semiconductor module according to some embodiments of the present inventive concepts.

### DETAIL DESCRIPTION OF EMBODIMENTS

The following will now describe a semiconductor package according to embodiments of the present inventive concepts with reference to the accompanying drawings.

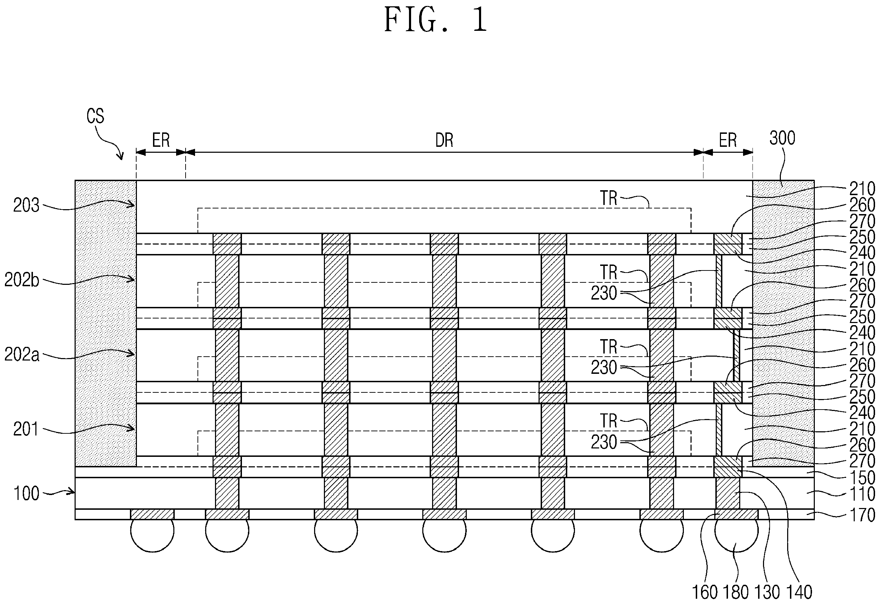

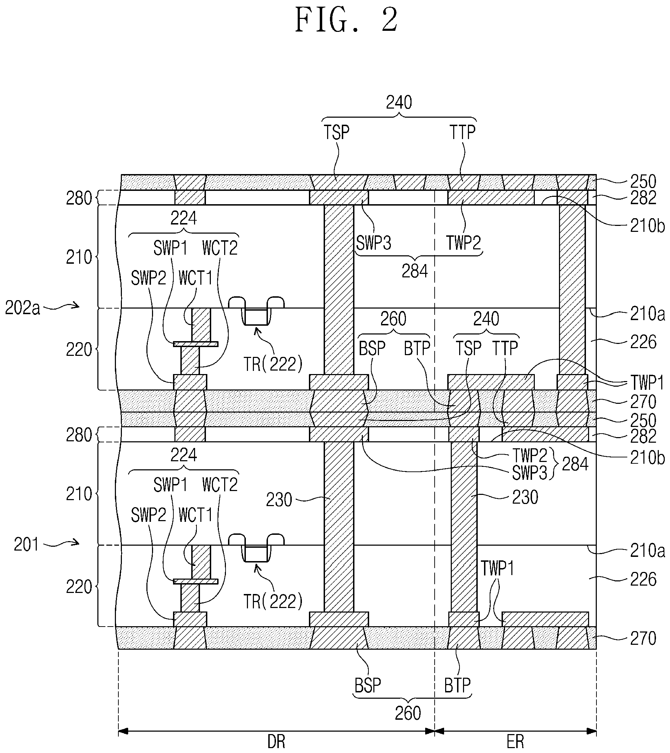

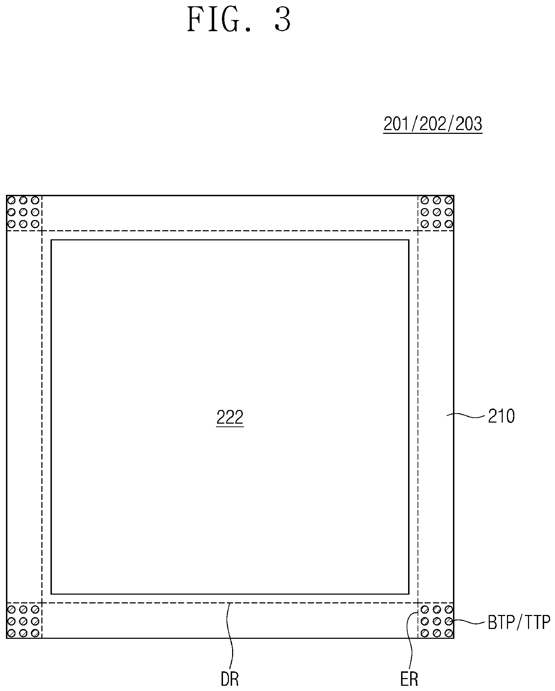

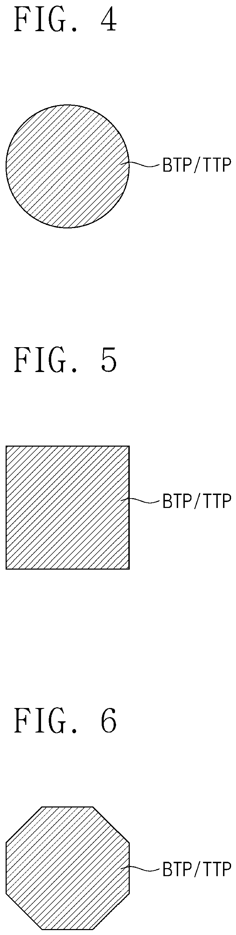

FIG. 1 illustrates a cross-sectional view showing a semiconductor package according to some embodiments of the present inventive concepts. For convenience of description, some components will be omitted or many components will be merged into a single configuration in FIG. 1. FIG. 2 illustrates a cross-sectional view showing a bonding between semiconductor chips. FIG. 3 illustrates a plan view showing a semiconductor chip of a semiconductor package according to some embodiments of the present inventive concepts. FIGS. 4 to 6 illustrate diagrams showing planar shapes of test pads.

A semiconductor package according to some embodiments of the present inventive concepts may be a stacked package in which vias are used. For example, semiconductor chips of the same type may be stacked on a base substrate, and the semiconductor chips may be electrically connected to each other through vias that penetrate therethrough. The semiconductor chips may be bonded to each other through their pads that face each other.

Referring to FIG. 1, a base substrate 100 may be provided. The base substrate 100 may include an integrated circuit therein. The base substrate 100 may be a first semiconductor chip that includes one or more electronic elements such as a transistor. For example, the base substrate 100 may be a wafer-level die formed of a semiconductor such as silicon (Si). FIG. 1 shows that the base substrate 100 is a first semiconductor chip, but the present inventive concepts are not limited thereto. According to some embodiments of the present inventive concepts, the base substrate 100 may be a substrate, such as a printed circuit board (PCB), which does not include an electronic element such as a transistor. A silicon wafer may have a thickness less than that of a printed circuit board (PCB). The following will describe an example in which the base substrate 100 and a first semiconductor chip are the same component.

The first semiconductor chip 100 may include a first semiconductor substrate 110, a first via 130, a first upper pad 140, a first upper protection layer 150, and a first lower protection layer 170. Components described herein may be described in the singular, but are provided in plural. Also, ordinal numbers such as "first," "second," "third," etc. may be used simply as labels of certain elements, steps, etc., to distinguish such elements, steps, etc. from one another. Terms that are not described using "first," "second," etc., in the specification, may still be referred to as "first" or "second" in a claim. In addition, a term that is referenced with a particular ordinal number (e.g., "first" in a particular claim) may be described elsewhere with a different ordinal number (e.g., "second" in the specification or another claim).

The first semiconductor substrate 110 may be provided. The first semiconductor substrate 110 may include or be formed of a semiconductor material. For example, the first semiconductor substrate 110 may be a monocrystalline silicon (Si) substrate.

Although not shown, a first circuit layer may be provided on a bottom surface of the first semiconductor substrate 110. The first circuit layer may include an integrated circuit. For example, the first circuit layer may be a memory circuit, a logic circuit, or a combination thereof. The bottom surface, on which the first circuit layer is provided, of the first semiconductor chip 100 may be an active surface. According to some embodiments, the first circuit layer may not be provided. The base substrate 100 may not be the first semiconductor chip, but may be a substrate that does not include an electric element such as a transistor.

The first via 130 may vertically penetrate the first semiconductor substrate 110. For example, the first via 130 may connect the first circuit layer to a top surface of the first semiconductor substrate 110. The first via 130 and the first circuit layer may be electrically connected to each other. The first via 130 may be provided in plural. A dielectric layer (not shown) may be provided as needed to surround the first via 130. For example, the dielectric layer (not shown) may include or be formed of at least one selected from silicon oxide (SiO), silicon nitride (SiN), silicon oxynitride (SiON), and low-k dielectric material. A low-k dielectric material may be a material that has a dielectric constant (k) that is small relative to silicon dioxide (e.g. that is smaller than silicon dioxide). The first via 130 may be formed, for example, of a metal or other conductive material. Also, some of the first vias 130 may be formed in the device region to connect to signal pads and signal wiring patterns, and other of the first vias 130, which may have the same size as, or may be wider or narrower than the first vias 130 formed in the device region, may be formed in the edge region to connect to test pads and test wiring patterns. As used herein, items described as being "electrically connected" are configured such that an electrical signal can be passed from one item to the other. Therefore, a passive electrically conductive component (e.g., a wire, pad, internal electrical line, etc.) physically connected to a passive electrically insulative component (e.g., a prepreg layer of a printed circuit board, an electrically insulative adhesive connecting two devices, an electrically insulative underfill or mold layer, etc.) is not electrically connected to that component. Moreover, items that are "directly electrically connected," to each other are electrically connected through one or more passive elements, such as, for example, wires, pads, internal electrical lines, through vias, etc. As such, directly electrically connected components do not include components electrically connected through active elements, such as transistors or diodes. Directly electrically connected elements may be directly physically connected and directly electrically connected.

The first upper pad 140 may be disposed on the top surface of the first semiconductor substrate 110. The first upper pad 140 may be coupled to the first via 130. The first upper pad 140 may be provided in plural. In this case, the plurality of first upper pads 140 may be correspondingly coupled to a plurality of first vias 130, and an arrangement of the first upper pads 140 may conform to that of the first vias 130. The first upper pad 140 may be coupled through the first via 130 to the first circuit layer. The first upper pad 140 may include or be formed of a metallic material, such as one or more of copper (Cu), aluminum (Al), nickel (Ni), and any other suitable element.

The first upper protection layer 150 may be disposed on the top surface of the first semiconductor substrate 110 to encapsulate the first upper pad 140. The first upper protection layer 150 may expose the first upper pad 140. A top surface of the first upper protection layer 150 may be coplanar with that of the first upper pad 140. The first semiconductor substrate 110 may be protected by the first upper protection layer 150. The first upper pad 140 may be connected to the first via 130. The first upper protection layer 150 may include or be formed of one of high density plasma (HDP) oxide, undoped silicate glass (USG), tetraethyl orthosilicate (TEOS), silicon nitride (SiN), silicon oxide (SiO), silicon carboxide (SiOC), silicon oxynitride (SiON), and silicon carbonitride (SiCN). Terms such as "same," "equal," "planar," "coplanar," "parallel," and "perpendicular," as used herein encompass identicality or near identicality including variations that may occur, for example, due to manufacturing processes. The term "substantially" may be used herein to emphasize this meaning, unless the context or other statements indicate otherwise.

The first lower pad 160 may be disposed on the bottom surface of the first semiconductor substrate 110. For example, the first lower pad 160 may be disposed on the bottom surface of the first semiconductor substrate 110 or on a bottom surface of the first circuit layer. The first lower pad 160 may be electrically connected to the first circuit layer. The first lower pad 160 may be provided in plural. The first lower pad 160 may include or be formed of a metallic material, such as one or more of copper (Cu), aluminum (Al), nickel (Ni), and any other suitable element.

The first semiconductor chip 100 may further include the first lower protection layer 170. The first lower protection layer 170 may be disposed on the bottom surface of the first semiconductor substrate 110 to cover the first semiconductor substrate 110. A bottom surface of the first lower protection layer 170 may expose the first lower pad 160. The first circuit layer may be protected by the first lower protection layer 170. The first lower protection layer 170 may be, for example, a dielectric coating layer including epoxy resin.

An external terminal 180 may be provided on a bottom surface of the first semiconductor chip 100. The external terminal 180 may be disposed on the first lower pad 160. The external terminal 180 may be electrically connected to the first semiconductor substrate 110 and the first via 130. Alternatively, the external terminal 180 may be disposed directly on the first via 130. In this case, the first via 130 may be exposed on the bottom surface of the first semiconductor substrate 110, and the external terminal 180 may be directly connected to the first via 130. The external terminal 180 may be provided in plural. In this case, the plurality of external terminals 180 may be correspondingly coupled to a plurality of first lower pads 160. The external terminal 180 may be an alloy that includes at least one selected from tin (Sn), silver (Ag), copper (Cu), nickel (Ni), bismuth (Bi), indium (In), antimony (Sb), and cerium (Ce). It will be understood that when an element is referred to as being "connected" or "coupled" to or "on" another element, it can be directly connected or coupled to or on the other element or intervening elements may be present. In contrast, when an element is referred to as being "directly connected" or "directly coupled" to another element, or as "contacting" or "in contact with" another element (or using any form of the word "contact"), or as "bonded to" another element, there are no intervening elements present at the point of contact.

A chip stack CS may be disposed on the first semiconductor chip 100. The chip stack CS may include a plurality of second semiconductor chips 201, 202a, 202b, and 203. The second semiconductor chips 201, 202a, 202b, and 203 may be of the same type. For example, the second semiconductor chips 201, 202a, 202b, and 203 may be memory chips. The chip stack CS may include a lower semiconductor chip 201 directly connected to the first semiconductor chip 100, intermediate semiconductor chips 202a and 202b disposed on the lower semiconductor chip 201, and an upper semiconductor chip 203 disposed on the intermediate semiconductor chips 202a and 202b. The lower semiconductor chip 201, the intermediate semiconductor chips 202a and 202b, and the upper semiconductor chip 203 may be sequentially stacked on the first semiconductor chip 100. The intermediate semiconductor chips 202a and 202b may be stacked on each other between the lower semiconductor chip 201 and the upper semiconductor chip 203. In the present embodiment, it is explained that two intermediate semiconductor chips 202a and 202b are interposed between the lower semiconductor chip 201 and the upper semiconductor chip 203, but the present inventive concepts are not limited thereto. According to some embodiments, one or more than three intermediate semiconductor chips may be interposed between the lower semiconductor chip 201 and the upper semiconductor chip 203, or no intermediate semiconductor chip may be provided between the lower semiconductor chip 201 and the upper semiconductor chip 203.

Referring to FIGS. 1 to 3, the lower semiconductor chip 201 may include a second semiconductor substrate 210, a second circuit layer 220, a second via 230, a second upper pad 240, a second upper protection layer 250, a second lower pad 260, a second lower protection layer 270, and a redistribution layer 280.

The second semiconductor substrate 210 may be provided. The second semiconductor substrate 210 may include or be formed of a semiconductor material. For example, the second semiconductor substrate 210 may be a monocrystalline silicon (Si) substrate.

The second semiconductor substrate 210 may have a device region DR and an edge region ER. When viewed in a plan view, the device region DR may be positioned on a central portion of the second semiconductor substrate 210, and as shown in FIG. 3, the edge region ER may be adjacent to a corner of the second semiconductor substrate 210. When viewed in a plan view, the corner of the second semiconductor substrate 210 may denote a corner where lateral surfaces of the second semiconductor substrate 210 meet each other. The edge region ER may be positioned between the device region DR and the corner of the second semiconductor substrate 210. The device region DR may be a zone where semiconductor elements of the lower semiconductor chip 201 are provided on the central portion of the second semiconductor substrate 210. The edge region ER may be a test region where patterns are provided for testing a bonding between the second semiconductor chips 201, 202a, 202b, and 203 on a zone in the vicinity of the corner of the second semiconductor substrate 210, wherein the corner is not provided with active semiconductor elements (e.g., transistors). The second semiconductor substrate 210 may have a first surface 210a and a second surface 210b that are opposite to each other. The first surface 210a may be a front surface of the second semiconductor substrate 210, and the second surface 210b may be a rear surface of the second semiconductor substrate 210. The front surface 210a of the second semiconductor substrate 210 may be defined to indicate a surface on which semiconductor elements are formed (mounted) or wiring lines and pads are formed, and the rear surface 210b of the second semiconductor substrate 210 may be defined to indicate a surface opposite to the front surface 210a. The first surface 210a of the second semiconductor substrate 210 may be directed toward (e.g., may face) the first semiconductor chip 100. For example, a bottom surface of the second semiconductor substrate 210 may be an active surface.

The lower semiconductor chip 201 may include the second circuit layer 220 that faces the first semiconductor chip 100. The second circuit layer 220 may include a semiconductor element 222 and a device wiring part 224.

The semiconductor element 222 may include a transistor TR provided on the first surface 210a on the device region DR of the second semiconductor substrate 210. For example, the transistor TR may include a source and a drain that are formed on a lower portion of the second semiconductor substrate 210, a gate electrode disposed on the first surface 210a of the second semiconductor substrate 210, and a gate dielectric layer interposed between the second semiconductor substrate 210 and the gate electrode. FIG. 2 shows that one transistor TR is provided, but the present inventive concepts are not limited thereto. The semiconductor element 222 may include a plurality of transistors TR. The semiconductor element 222 may include a memory circuit, for example including memory cells, each including at least one transistor TR. Although not shown, on the device region DR, the semiconductor element 222 may include a shallow device isolation pattern, a logic cell or a plurality of memory cells on the first surface 210a. Alternatively, the semiconductor element 222 may include a passive element such as a capacitor. In one embodiment, no semiconductor elements are disposed on the edge region ER of the second semiconductor substrate 210.

The first surface 210a of the second semiconductor substrate 210 may be covered with a device interlayer dielectric layer 226. On the device region DR, the device interlayer dielectric layer 226 may bury the semiconductor element 222. The device interlayer dielectric layer 226 may downwardly cover the semiconductor element 222. For example, the semiconductor element 222 may not be exposed by the device interlayer dielectric layer 226. A lateral surface of the device interlayer dielectric layer 226 may be aligned with that of the second semiconductor substrate 210. The device interlayer dielectric layer 226 may include or be formed of, for example, at least one selected from silicon oxide (SiO), silicon nitride (SiN), and silicon oxynitride (SiON). Although not shown, the device interlayer dielectric layer 226 may include a low-k dielectric material. The device interlayer dielectric layer 226 may have a mono-layered structure or a multi-layered structure. When the device interlayer dielectric layer 226 is provided in the form of the multi-layered structure, subsequently described wiring layers may be provided in each dielectric layer, and an etch stop layer may be interposed between the dielectric layers. For example, the etch stop layer may be provided on a bottom surface of each of the dielectric layers. The etch stop layer may include or be formed of, for example, one of silicon nitride (SiN), silicon oxynitride (SiON), and silicon carbonitride (SiCN).

On the device region DR, the device interlayer dielectric layer 226 may be provided therein with the device wiring part 224 connected to the transistors TR.

The device wiring part 224 may include first signal wiring patterns SWP1 buried in the device interlayer dielectric layer 226 and second signal wiring patterns SWP2 positioned on the first signal wiring patterns SWP1. The first signal wiring patterns SWP1 and the second signal wiring patterns SWP2 may be patterns for horizontal connection. The first signal wiring patterns SWP1 may be positioned between top and bottom surfaces of the device interlayer dielectric layer 226. The second signal wiring patterns SWP2 may be disposed on a lower portion of the device interlayer dielectric layer 226. For example, bottom surfaces of the second signal wiring patterns SWP2 may be exposed on the bottom surface of the device interlayer dielectric layer 226. The second signal wiring patterns SWP2 may be wiring patterns at a lowermost portion of the device wiring part 224 provided in the device interlayer dielectric layer 226. The second signal wiring patterns SWP2 may each have a thickness greater than that of each of the first signal wiring patterns SWP1. Neither the first signal wiring patterns SWP1 nor the second signal wiring patterns SWP2 are positioned on the edge region ER. The first signal wiring patterns SWP1 and the second signal wiring patterns SWP2 may include, for example, copper (Cu) or tungsten (W).

The device wiring part 224 may further include first connection contacts WCT1 that connect the first signal wiring patterns SWP1 to the semiconductor element 222 or the first signal wiring patterns SWP1 to the second semiconductor substrate 210, and may also further include second connection contacts WCT2 that connect the first signal wiring patterns SWP1 to the second signal wiring patterns SWP2. The first connection contacts WCT1 and the second connection contacts WCT2 may be patterns for vertical connection. The first connection contacts WCT 1 may vertically penetrate the device interlayer dielectric layer 226 to be connected to ones of source electrodes, drain electrodes, and gate electrodes of the transistors TR. Alternatively, the first connection contacts WCT1 may be connected to various components of the semiconductor element 222. The first connection contacts WCT1 may vertically penetrate the device interlayer dielectric layer 226 to be coupled to top surfaces of the first signal wiring patterns SWP1. The second connection contacts WCT2 may vertically penetrate the device interlayer dielectric layer 226 to be coupled to bottom surfaces of the first signal wiring patterns SWP1 and top surfaces of the second signal wiring patterns SWP2. The first connection contacts WCT1 and the second connection contacts WCT2 may include or be formed of, for example, tungsten (W).

FIG. 2 depicts that one wiring layer, or the first signal wiring patterns SWP1, is provided between the second semiconductor substrate 210 and the second signal wiring patterns SWP2, but the present inventive concepts are not limited thereto. According to some embodiments, a plurality of wiring layers may be provided between the second semiconductor substrate 210 and the second signal wiring patterns SWP2. The following description will focus on the embodiment of FIG. 2.

On the edge region ER, one or more first test wiring patterns TWP1 may be provided in the device interlayer dielectric layer 226. The first test wiring pattern TWP 1 may be located at the same level as that of the second signal wiring patterns SWP2, and may include the same material as that of the second signal wiring patterns SWP2. For example, the second signal wiring patterns SWP2 and the first test wiring pattern TWP1 may be patterns formed by patterning one metal layer, and may be formed at the same time during fabrication. The first test wiring pattern TWP1 may have a thickness the same as that of the second signal wiring pattern SWP2. A bottom surface of the first test wiring pattern TWP1 may be exposed on the bottom surface of the device interlayer dielectric layer 226. For example, the bottom surface of the first test wiring pattern TWP1 may be coplanar with that of the device interlayer dielectric layer 226. The bottom surface of the first test wiring pattern TWP1 may be substantially flat, and likewise the bottom surface of the device interlayer dielectric layer 226 may be substantially flat. On the edge region ER, the first test wiring pattern TWP1 may be positioned between the device region DR and the corner of the second semiconductor substrate 210. The first test wiring pattern TWP1 may be spaced apart from the lateral surface of the second semiconductor substrate 210. The first test wiring pattern TWP1 may be spaced apart from the second signal wiring patterns SWP2, for example, from the device region DR. The first test wiring pattern TWP1 may have a plate shape. The first test wiring patterns TWP1 may be electrically insulated from any semiconductor elements 222 and from the device wiring part 224. For example, the first test wiring patterns TWP1 may be electrically floated in a semiconductor package. For example, the first test wiring patterns TWP1 may not be connected to any active components and may be part of a wiring pattern that receives a test signal at one end, and does not output any signal to any circuit at the other end because the other end is floating. The first test wiring patterns TWP1 may not be disposed on the device region DR of the second semiconductor substrate 210.

The second circuit layer 220 may constitute the semiconductor element 222, the transistors TR of the semiconductor element 222, the device interlayer dielectric layer 226, and the device wiring part 224.

The device wiring part 224 may further include second vias 230 that vertically penetrate the second semiconductor substrate 210 to be connected to the second signal wiring patterns SWP2. The second vias 230 may be patterns for vertical connection. The second vias 230 may vertically penetrate the device interlayer dielectric layer 226 to be coupled to the top surfaces of some of the second signal wiring patterns SWP2. The second vias 230 may vertically penetrate the device interlayer dielectric layer 226 and the second semiconductor substrate 210 to be exposed on a top surface of the second semiconductor substrate 210. The second vias 230 may include or be formed of, for example, tungsten (W).

The second lower pads 260 may be disposed on the device interlayer dielectric layer 226. The second lower pads 260 may include lower signal pads BSP and lower test pads BTP.

The lower signal pads BSP may be disposed on the device region DR. The lower signal pads BSP may be disposed on the bottom surfaces of the second signal wiring patterns SWP2. The lower signal pads BSP may be electrically connected to the semiconductor element 222. For example, as shown in FIG. 2, on the device region DR, the lower signal pads BSP may be coupled to the bottom surfaces of the second signal wiring patterns SWP2 included in the device wiring part 224. The second signal wiring patterns SWP2 may be under pads of the lower signal pads BSP. The second signal wiring patterns SWP2 may electrically connect the semiconductor element 222 to the lower signal pads BSP. The lower signal pads BSP may have plate shapes, e.g., to have substantially flat upper and lower surfaces. According to some embodiments, the lower signal pads BSP may each have a T shaped cross-section including a via part and a pad part on the via part, which via and pad parts are connected into a single unitary piece. The lower signal pads BSP may include or be formed of a metallic material. For example, the lower signal pads BSP may include or be formed of copper (Cu).

The lower test pads BTP may be disposed on the edge region ER. The lower test pads BTP may be disposed on the bottom surface of the first test wiring pattern TWP1. When viewed in a plan view, the lower test pads BTP may be arranged in a plurality of rows and columns. The lower test pads BTP may each have a horizontal width of about 2 µm to about 50 µm. An interval between the lower test pads BTP may range from about 2 µm to about 50 µm. Terms such as "about" or "approximately" may reflect amounts, sizes, orientations, or layouts that vary only in a small relative manner, and/or in a way that does not significantly alter the operation, functionality, or structure of certain elements. For example, a range from "about 0.1 to about 1" may encompass a range such as a 0%-5% deviation around 0.1 and a 0% to 5% deviation around 1, especially if such deviation maintains the same effect as the listed range. The lower test pads BTP may each have a circular planar shape as shown in FIG. 4. Alternatively, the lower test pads BTP may each have a polygonal planar shape, such as a tetragonal planar shape as shown in FIG. 5 or an octagonal planar shape as shown in FIG. 6. The lower test pads BTP may each have a plate shape, e.g., to have substantially flat upper and lower surfaces. According to some embodiments, the lower test pads BTP may each have a T shaped cross-section including a via part and a pad part on the via part, which via and pad parts are connected into a single unitary piece. The lower test pads BTP may include or be formed of a metallic material. For example, the lower test pads BTP may include or be formed of copper (Cu).

The first test wiring pattern TWP1 may electrically connect two neighboring lower test pads BTP to each other. The connection between the first test wiring pattern TWP1 and the lower test pads BTP will be further discussed in detail below. A test pattern may be constituted by the first test wiring pattern TWP1 and the lower test pads BTP.

The second lower protection layer 270 may be disposed on the device interlayer dielectric layer 226. On the bottom surface of the device interlayer dielectric layer 226, the second lower protection layer 270 may cover the second signal wiring patterns SWP2 and the first test wiring pattern TWP1. On the bottom surface of the device interlayer dielectric layer 226, the second lower protection layer 270 may surround the second lower pads 260. The second lower pads 260 may be exposed by the second lower protection layer 270. For example, when viewed in a plan view, the second lower protection layer 270 may surround, the second lower pads 260. A bottom surface of the second lower protection layer 270 may be coplanar with those of the second lower pads 260. The second lower protection layer 270 may include or be formed of one of silicon nitride (SiN), silicon oxide (SiO), silicon carboxide (SiOC), silicon oxynitride (SiON), and silicon carbonitride (SiCN).

The redistribution layer 280 may be disposed on the second surface 210b of the second semiconductor substrate 210. The redistribution layer 280 may include third signal wiring patterns SWP3, a second test wiring pattern TWP2, and a redistribution dielectric pattern 282.

The redistribution dielectric pattern 282 may be disposed on the second surface 210b of the second semiconductor substrate 210. The redistribution dielectric pattern 282 may include or be formed of one of silicon nitride (SiN), silicon oxide (SiO), and silicon oxynitride (SiON).

On the device region DR, the third signal wiring patterns SWP3 may be disposed in the redistribution dielectric pattern 282. Some of the third signal wiring patterns SWP3 may be connected to the second vias 230. For example, the second vias 230 may vertically penetrate the second semiconductor substrate 210 to be coupled to bottom surfaces of the third signal wiring patterns SWP3. The third signal wiring patterns SWP3 are not positioned on the edge region ER. The third signal wiring patterns SWP3 may include or be formed of, for example, copper (Cu) or tungsten (W).

On the edge region ER, the second test wiring pattern TWP2 may be provided in the redistribution dielectric pattern 282. The second test wiring pattern TWP2 may be located at the same vertical level as that of the third signal wiring patterns SWP3, and may include the same material as that of the third signal wiring patterns SWP3. For example, the third signal wiring patterns SWP3 and the second test wiring pattern TWP2 may be patterns formed by patterning one metal layer, and may be patterned at the same time in the same process. The second test wiring pattern TWP2 may have a thickness the same as that of the third signal wiring pattern SWP3. On the edge region ER, the second test wiring pattern TWP2 may be positioned between the device region DR and the corner of the second semiconductor substrate 210. The second test wiring pattern TWP2 may be spaced apart from the lateral surface of the second semiconductor substrate 210. The second test wiring pattern TWP2 may be spaced apart from the third signal wiring patterns SWP3, for example, from the device region DR. The second test wiring pattern TWP2 may have a plate shape, for example, having substantially flat upper and lower surfaces. The second test wiring pattern TWP2 may be electrically insulated from any semiconductor elements 222 and any device wiring parts 224. In addition, the second test wiring pattern TWP2 may be electrically insulated from other elements and wiring lines in a semiconductor package. One of the second test wiring patterns TWP2 may be connected through one of the second vias 230 to one of the first test wiring patterns TWP1. For example, the first test wiring pattern TWP1 and the second test wiring patterns TWP2 may be electrically floated in a semiconductor package. The second test wiring pattern TWP2 may not be disposed on the device region DR of the second semiconductor substrate 210.

The third signal wiring patterns SWP3 and the second test wiring pattern TWP2 may have their top surfaces that are exposed on a top surface of the redistribution dielectric pattern 282. For example, the third signal wiring patterns SWP3, the second test wiring pattern TWP2, and the redistribution dielectric pattern 282 may have their top surfaces that are coplanar with each other. In this configuration, the third signal wiring patterns SWP3, the second test wiring pattern TWP2, and the redistribution dielectric pattern 282 may have substantially flat top surfaces.

The second upper pads 240 may be disposed on the redistribution layer 280. The second upper pads 240 may include upper signal pads TSP and upper test pads TTP.

The upper signal pads TSP may be disposed on the device region DR. The upper signal pads TSP may be disposed on the top surfaces of the third signal wiring patterns SWP3. The third signal wiring patterns SWP3 may be under pads of the upper signal pads TSP. The third signal wiring patterns SWP3 may electrically connect the semiconductor elements 222 to the upper signal pads TSP. The upper signal pads TSP may have a plate shapes, for example having substantially flat upper and lower surfaces. According to some embodiments, the upper signal pads TSP may each have a T shaped cross-section including a via part and a pad part on the via part, which via and pad parts are connected into a single unitary piece. The upper signal pads TSP may include or be formed of a metallic material. For example, the upper signal pads TSP may include copper (Cu).

The upper test pads TTP may be disposed on the edge region ER. The upper test pads TTP may be disposed on a top surface of the second test wiring pattern TWP2. When viewed in a plan view, the upper test pads TTP may be arranged in a plurality of rows and columns. The upper test pads TTP may each have a width of about 2 µm to about 50 µm. An interval between the upper test pads TTP may range from about 2 µm to about 50 µm. The upper test pads TTP may each have a circular planar shape as shown in FIG. 4. Alternatively, the upper test pads TTP may each have a polygonal planar shape, such as a tetragonal planar shape as shown in FIG. 5 or an octagonal planar shape as shown in FIG. 6. The upper test pads TTP may each have a plate shape, for example having substantially flat upper and lower surfaces. According to some embodiments, the upper test pads TTP may each have a T shaped cross-section including a via part and a pad part on the via part, which via and pad parts are connected into a single unitary piece. The upper test pads TTP may include or be formed of a metallic material. For example, the upper test pads TTP may include copper (Cu).

The second test wiring pattern TWP2 may electrically connect two neighboring upper test pads TTP to each other. The connection between the second test wiring pattern TWP2 and the upper test pads TTP will be further discussed in detail below. A test pattern may be constituted by the second test wiring pattern TWP2 and the upper test pads TTP. Similarly, a test pattern may be constituted by the first test wiring pattern TWP1 and the lower test pads BTP.

The second upper protection layer 250 may be disposed on the redistribution layer 280. On a top surface of the redistribution layer 280, the second upper protection layer 250 may cover the third signal wiring patterns SWP3 and the second test wiring pattern TWP2. On the top surface of the redistribution layer 280, the second upper protection layer 250 may surround the second upper pads 240. The second upper pads 240 may be exposed by the second upper protection layer 250. For example, when viewed in a plan view, the second upper protection layer 250 may surround, the second upper pads 240. A top surface of the second upper protection layer 250 may be coplanar with those of the second upper pads 240. The second upper protection layer 250 may include or be formed of one of high density plasma (HDP) oxide, undoped silicate glass (USG), tetraethyl orthosilicate (TEOS), silicon nitride (SiN), silicon oxide (SiO), silicon carboxide (SiOC), silicon oxynitride (SiON), and silicon carbonitride (SiCN). The second upper protection layer 250 may have a mono-layered structure or a multi-layered structure.

The intermediate semiconductor chips 202a and 202b may have substantially the same structure as that of the lower semiconductor chip 201. For example, each of the intermediate semiconductor chips 202a and 202b may include the second semiconductor substrate 210, the second circuit layer 220, the second via 230, the second upper pad 240, the second upper protection layer 250, the second lower pad 260, the second lower protection layer 270, and the redistribution layer 280.

The upper semiconductor chip 203 may have a similar structure to that of the lower semiconductor chip 201. For example, the upper semiconductor chip 203 may include the second semiconductor substrate 210, the second circuit layer 220, the second lower pad 260, and the second lower protection layer 270. The upper semiconductor chip 203 may not have any of the second via 230, the second upper pad 240, the second upper protection layer 250, and the redistribution layer 280. The present inventive concepts, however, are not limited thereto. According to some embodiments, the upper semiconductor chip 203 may include at least one selected from the second via 230, the second upper pad 240, the second upper protection layer 250, and the redistribution layer 280. The upper semiconductor chip 203 may have a thickness greater than that of the lower semiconductor chip 201 and those of the intermediate semiconductor chips 202a and 202b.

The intermediate semiconductor chips 202a and 202b and the upper semiconductor chip 203 may be sequentially mounted on the lower semiconductor chip 201. The semiconductor chips 201, 202a, 202b, and 203 of the chip stack CS may be mounted in the same method. With regard to the mounting of the semiconductor chips 201, 202a, 202b, and 203, the following will describe in detail the mounting of the lower semiconductor chip 201 and one 202a among the intermediate semiconductor chips 202a and 202b of the chip stack CS.

The intermediate semiconductor chip 202a may be disposed on the lower semiconductor chip 201. The second upper pads 240 of the lower semiconductor chip 201 may be vertically aligned with the second lower pads 260 of the intermediate semiconductor chip 202a. The lower semiconductor chip 201 and the intermediate semiconductor chip 202a may be in contact with each other.

At an interface between the lower semiconductor chip 201 and the intermediate semiconductor chip 202a, the second upper protection layer 250 of the lower semiconductor chip 201 may be bonded to the second lower protection layer 270 of the intermediate semiconductor chip 202a. In this configuration, the second upper protection layer 250 and the second lower protection layer 270 may constitute a hybrid bonding of oxide, nitride, or oxynitride. In this description, the term "hybrid bonding" may denote a bonding in which two components of the same kind are merged at an interface therebetween. The bonded second upper and lower protection layers 250 and 270 may have a continuous configuration, and an invisible interface may be provided between the second upper and lower protection layers 250 and 270. For example, the second upper protection layer 250 and the second lower protection layer 270 may be formed of the same material and may have no interface therebetween. Therefore, the second upper protection layer 250 and the second lower protection layer 270 may be provided in the form of one component. For example, the second upper protection layer 250 and the second lower protection layer 270 may be combined to constitute a single unitary piece. The present inventive concepts, however, are not limited thereto. The second upper protection layer 250 and the second lower protection layer 270 may be formed of different materials from each other. The second upper protection layer 250 and the second lower protection layer 270 may not have a continuous configuration and may have a visible interface therebetween.

The lower semiconductor chip 201 may be connected to the intermediate semiconductor chip 202a. For example, the lower semiconductor chip 201 and the intermediate semiconductor chip 202a may be in contact with each other. At an interface between the lower semiconductor chip 201 and the intermediate semiconductor chip 202a, the second upper pads 240 of the lower semiconductor chip 201 may be bonded to the second lower pads 260 of the intermediate semiconductor chip 202a. For example, the upper signal pads TSP of the lower semiconductor chip 201 may be bonded to the lower signal pads BSP of the intermediate semiconductor chip 202a, and the upper test pads TTP of the lower semiconductor chip 201 may be bonded to the lower test pads BTP of the intermediate semiconductor chip 202a. In this configuration, the second upper and lower pads 240 and 260 may constitute an intermetallic hybrid bonding therebetween. The bonded second upper and lower pads 240 and 260 may have a continuous configuration and may have an invisible interface therebetween. For example, the second upper and lower pads 240 and 260 may be formed of the same material and may not have an interface therebetween. Thus, the second upper and lower pads 240 and 260 may be provided in the form of one component. For example, the second upper and lower pads 240 and 260 may be combined to constitute a single unitary piece.

As the lower semiconductor chip 201 and the intermediate semiconductor chip 202a are bonded to each other, on the edge region ER, the second test wiring pattern TWP2 and the upper test pads TTP of the lower semiconductor chip 201 may be electrically connected with the lower test pads BTP and the first test wiring pattern TWP1 of the intermediate semiconductor chip 202a. In this configuration, the second test wiring pattern TWP2 and the upper test pads TTP of the lower semiconductor chip 201 may be connected in series with the lower test pads BTP and the first test wiring pattern TWP1 of the intermediate semiconductor chip 202a. A combination of the lower test pads BTP, first test wiring patterns TWP1, second vias 230 in the edge region, second test wiring patterns TWP2, and upper test pads TTP for the various stacked semiconductor chips may be described as a test circuit, and may have a daisy chain configuration, connecting through and from each interface between two adjacent semiconductor chips through a semiconductor chip to the next interface between two adjacent semiconductor chips. The following will describe in detail the connection between the second test wiring pattern TWP2 and the upper test pads TTP of the lower semiconductor chip 201 and the lower test pads BTP and the first test wiring pattern TWP1 of the intermediate semiconductor chip 202a.

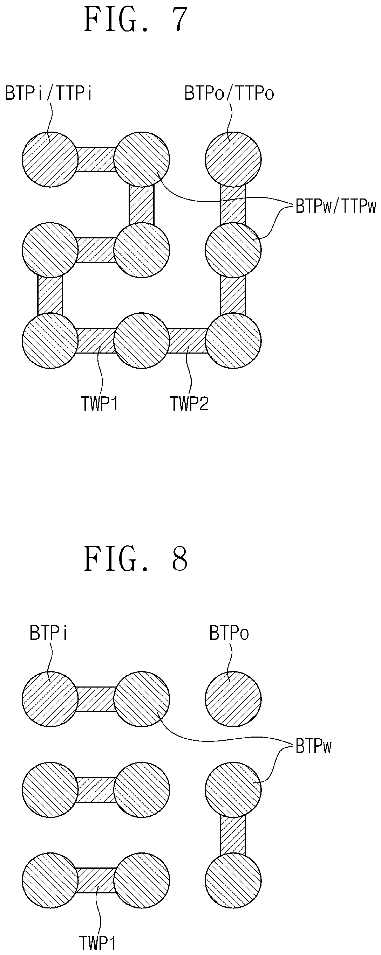

FIGS. 7 to 9 illustrate plan views showing an arrangement and connection relation between test pads.

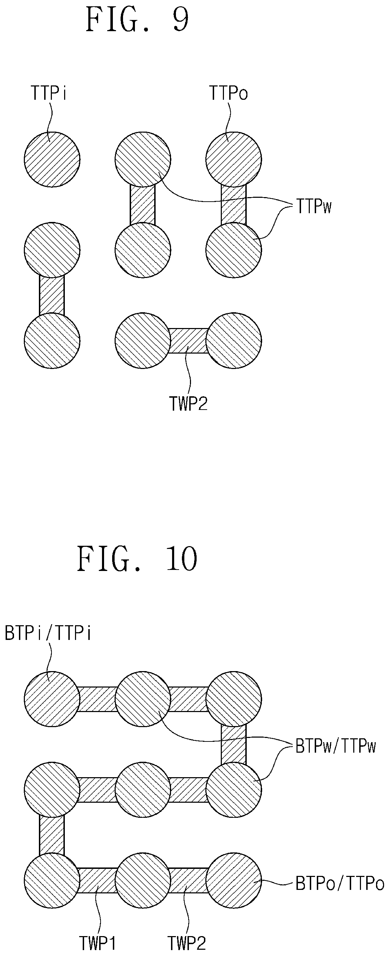

Referring to FIGS. 2 and 7 to 9, when viewed in a plan view, the lower test pads BTP may be arranged in a plurality of rows and columns. When viewed in a plan view, the upper test pads TTP may be arranged in a plurality of rows and columns. The lower test pads BTP may be aligned to face corresponding upper test pads TTP. The lower test pads BTP may include one first in-pad BTPi, one first out-pad BTPo, and remaining first connection pads BTPw. The upper test pads TTP may include one second in-pad TTPi, one second out-pad TTPo, and remaining second connection pads TTPw. The first in-pad BTPi may be bonded to the second in-pad TTPi, the first out-pad BTPo may be bonded to the second out-pad TTPo, and the first connection pads BTPw may be correspondingly bonded to the second connection pads TTPw. The second test wiring pattern TWP2 and the first test wiring pattern TWP1 may include a plurality of wiring lines, and each of the wiring lines may connect two neighboring ones of the first in-pad BTPi, the first out-pad BTPo, and the first connection pads BTPw to each other or may connect two neighboring ones of the second in-pad TTPi, the second out-pad TTPo, and the second connection pads TTPw to each other. For example, as shown in FIG. 8, the wiring lines of the first test wiring pattern TWP1 may connect a pair of neighboring ones of the first in-pad BTPi, the first out-pad BTPo, and the first connection pads BTPw to each other. All pairs of neighboring ones of the first in-pad BTPi, the first out-pad BTPo, and the first connection pads BTPw may not be physically connected to each other through direct connections with the first test wiring pattern TWP1. For example, a pair of lower test pads BTP may be directly physically connected to only one of the wiring lines of the first test wiring pattern TWP1. As shown in FIG. 9, the wiring lines of the second test wiring pattern TWP2 may connect a pair of neighboring ones of the second in-pad TTPi, the second out-pad TTPo, and the second connection pads TTPw to each other. All pairs of neighboring ones of the second in-pad TTPi, the second out-pad TTPo, and the second connection pads TTPw may not be physically connected to each other through direct connections with the second test wiring pattern TWP2. For example, a pair of upper test pads TTP may be directly physically connected to only one of the wiring lines of the second test wiring pattern TWP2. The wiring lines of the first test wiring pattern TWP1 may not vertically overlap the wiring lines of the second test wiring pattern TWP2. The first test wiring pattern TWP1, the second test wiring pattern TWP2, the first connection pads BTPw, and the second connection pads TTPw may constitute a series circuit (e.g., a series test circuit) between the first in-pad BTPi (the second in-pad TTPi) and the first out-pad BTPo (the second out-pad TTPo), wherein the first in-pad BTPi, the second in-pad TTPi, and the first out-pad BTPo may each be described as ends of the series circuit. The first in-pad BTPi (the second in-pad TTPi) and the first out-pad BTPo (the second out-pad TTPo) may be opposite ends of the series test circuit. In the series test circuit, the upper test pads TTP and the lower test pads BTP may be alternately connected to each other, so that each upper test pad TTP connects to another upper test pad TTP in one direction along the series circuit and to a lower test pad BTP in an opposite direction along the series circuit. As described herein, an "in-pad" may be a pad within a test circuit that is configured to receive an input signal during a testing process. Similarly, an "out-pad" may be a pad within a test circuit that is configured to output a signal during the testing process. Within a series testing circuit, an in-pad and an out-pad may be located at opposite ends of the series. In this context, connections in "opposite directions" to each other and pads at "opposite ends" to each other may relate to the order of connections and pads within the series circuit (e.g. towards or away from the in-pad), but need not relate to specific geometrical directions (e.g. the opposite directions need not be arranged 180° from each other). For instance, as shown in FIG. 7, the connections may form a zig-zag arrangement, with at least some of the connections being 90° to each other.

The second in-pad TTPi may be connected to one of the second vias 230 of the lower semiconductor chip 201. The first out-pad BTPo may be connected to one of the second vias 230 of the intermediate semiconductor chip 202a.

The bonding between the intermediate semiconductor chips 202a and 202b and the bonding between the upper semiconductor chip 203 and one 202b of the intermediate semiconductor chips 202a and 202b may be the same as that between the lower semiconductor chip 201 and the intermediate semiconductor chip 202a. Therefore, a series test circuit may be constituted by the lower test pads BTP of the upper semiconductor chip 203, the upper test pads TTP, the second vias 230, and the lower test pads BTP of the intermediate semiconductor chips 202a and 202b, and the upper test pads TTP, the second vias 230, and the lower test pads BTP of the lower semiconductor chip 201.

The chip stack CS may have the stacked semiconductor chips 201, 202a, 202b, and 203, wherein the semiconductor chips 201, 202a, 202b, and 203 may contact each other to achieve a hybrid bonding. In this configuration, the semiconductor chips 201, 202a, 202b, and 203 may easily become spaced apart from each other on the edge region ER farthest away from centers of the semiconductor chips 201, 202a, 202b, and 203. According to some embodiments of the present inventive concepts, on the edge region ER, the lower and upper test pads BTP and TTP of the semiconductor chips 201, 202a, 202b, and 203 may be bonded to each other. Therefore, it may be possible to easily test structural defects such as unintended spacing between the semiconductor chips 201, 202a, 202b, and 203 on the edge region ER. In addition, because the lower test pads BTP of the upper semiconductor chip 203, the upper test pads TTP, the second vias 230, and the lower test pads BTP of the intermediate semiconductor chips 202a and 202b, and the upper test pads TTP, the second vias 230, and the lower test pads BTP of the lower semiconductor chip 201 are all connected to each other to form one series circuit, it may be possible to have a simplified test circuit for detecting defects even on a wide area. It should be noted that a "test circuit" as described herein refers to a wiring that can receive a test signal, and that can be used based on the test signal to test characteristics of a semiconductor package. A method of testing structural defects of a semiconductor package will be discussed in detail below.

FIGS. 7 to 9 depict that the first in-pad BTPi, the second in-pad TTPi, the first out-pad BTPo, and the second out-pad TTPo are positioned on one row when viewed in a plan view, but the present inventive concepts are not limited thereto.

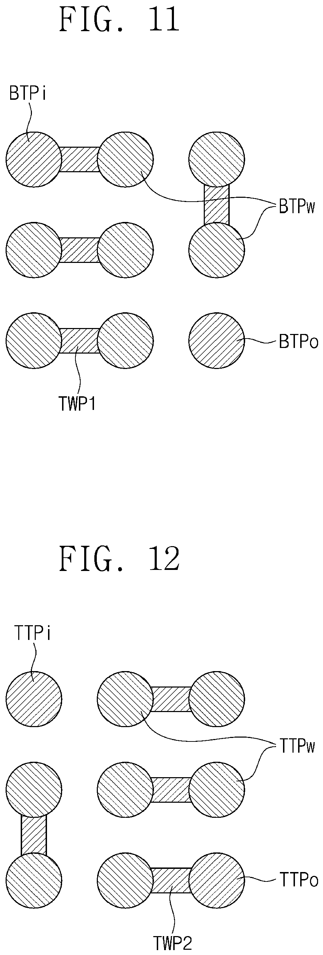

FIGS. 10 to 12 illustrate plan views showing an arrangement and connection relation between test pads. As shown in FIGS. 10 to 12, when viewed in a plan view, the first in-pad BTPi and the first out-pad BTPo may be positioned at opposite corners in rows and columns of the lower test pads BTP, and the second in-pad TTPi and the second out-pad TTPo may be position at opposite corners in rows and columns of the upper test pads TTP. The lower test pads BTP, the upper test pads TTP, the first test wiring pattern TWP1, and the second test wiring pattern TWP2 may be connected to form a zigzag shape when viewed in a plan view. An arrangement and connection relation between the lower test pads BTP, the upper test pads TTP, the first test wiring pattern TWP1, and the second test wiring pattern TWP2 shown in FIGS. 7 to 12 are a mere example of some embodiments of the present inventive concepts, and the present inventive concepts are not limited thereto. The arrangement of connection relation between the lower test pads BTP, the upper test pads TTP, the first test wiring pattern TWP1, and the second test wiring pattern TWP2 may include various arrangements and connection relations for a series circuit constituted by the first in-pad BTPi (the second in-pad TTPi), the first test wiring pattern TWP1, the second test wiring pattern TWP2, the first connection pads BTPw, the second connection pads TTPw, and the first out-pad BTPo (the second out-pad TTPo).

The chip stack CS may be mounted on the first semiconductor chip 100. The chip stack CS may be disposed on the first semiconductor chip 100. The first upper pads 140 of the first semiconductor chip 100 may be vertically aligned with the second lower pads 260 of the lower semiconductor chip 201. The first semiconductor chip 100 and the lower semiconductor chip 201 may be in contact with each other.

At an interface between the first semiconductor chip 100 and the lower semiconductor chip 201, the first upper protection layer 150 of the first semiconductor chip 100 may be bonded to the second lower protection layer 270 of the lower semiconductor chip 201. In this configuration, the first upper protection layer 150 and the second lower protection layer 270 may constitute a hybrid bonding of oxide, nitride, or oxynitride. For example, the first upper protection layer 150 and the second lower protection layer 270 may be formed of the same material and may have no interface therebetween. Thus, the first upper protection layer 150 and the second lower protection layer 270 may be provided in the form of one component.

The first semiconductor chip 100 may be connected to the lower semiconductor chip 201. For example, the first semiconductor chip 100 and the lower semiconductor chip 201 may be in contact with each other. On an interface between the first semiconductor chip 100 and the lower semiconductor chip 201, the first upper pads 140 of the first semiconductor chip 100 may be bonded to the second lower pads 260 of the lower semiconductor chip 201. In this configuration, the first upper pad 140 and the second lower pad 260 may constitute an intermetallic hybrid bonding therebetween. For example, the bonded first upper pad 140 and second lower pad 260 may have a continuous configuration and may have an invisible interface therebetween. The first upper pad 140 and the second lower pad 260 may be provided in the form of one component, which may be formed of two parts.

According to some embodiments, the chip stack CS may be mounted on the first semiconductor chip 100 through connection terminals such as solder balls. The connection terminals may be disposed between and connect the first upper pads 140 and the second lower pads 260. In this case, an under-fill material may be provided to a space between the chip stack CS and the first semiconductor chip 100, and the under-fill material may surround the connection terminals.

A molding layer 300 may be provided on the first semiconductor chip 100, and the molding layer 300 may cover a top surface of the first semiconductor chip 100. The molding layer 300 may surround the chip stack CS. For example, the molding layer 300 may cover lateral surfaces of the semiconductor chips 201, 202a, 202b, and 203. The molding layer 300 may protect the chip stack CS. The molding layer 300 may include or be formed of a dielectric material. For example, the molding layer 300 may include an epoxy molding compound (EMC). Differently from that shown, the molding layer 300 may be formed to cover the chip stack CS. For example, the molding layer 300 may cover a rear surface of the upper semiconductor chip 203.

In the embodiments that follow, a detailed description of technical features repetitive to those discussed with reference to FIGS. 1 to 12 will be omitted for convenience of description, and a difference thereof will be discussed in detail. The same reference numerals may be allocated to the same components as those of the semiconductor package discussed above according to some embodiments of the present inventive concepts.

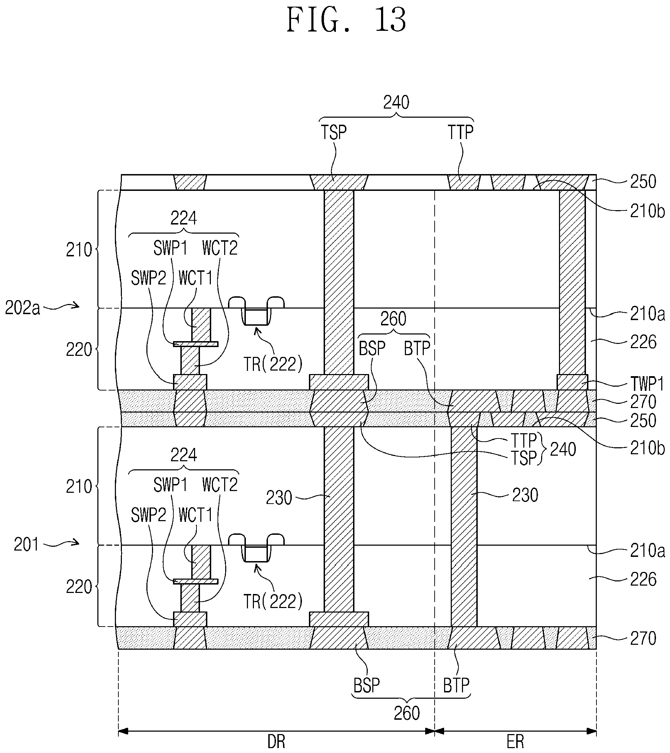

FIG. 13 illustrates a bonding between semiconductor chips.

Referring to FIGS. 1 and 13, the redistribution layer 280 may not be included in the semiconductor chips 201, 202a, 202b, and 203 of the chip stack CS in a semiconductor package.

The second upper pads 240 may be disposed on the second surface 210b of the second semiconductor substrate 210. The second upper pads 240 may include upper signal pads TSP and upper test pads TTP. Some of the upper signal pads TSP may be connected to the second vias 230. One of the upper test pads TTP may be connected through one of the second vias 230 to one of the first test wiring patterns TWP 1.

The second upper protection layer 250 may be disposed on the second surface 210b of the second semiconductor substrate 210. On the second surface 210b of the second semiconductor substrate 210, the second upper protection layer 250 may surround the second upper pads 240.

The second circuit layer 220 may not include the first test wiring pattern TWP1. Therefore, the lower test pads BTP may not be electrically connected through a wiring line in the second circuit layer 220.

The intermediate semiconductor chips 202a and 202b may be mounted on the lower semiconductor chip 201, and the upper semiconductor chip 203 may be mounted on the intermediate semiconductor chips 202a and 202b. The semiconductor chips 201, 202a, 202b, and 203 of the chip stack CS may be mounted in the same method. With regard to the mounting of the semiconductor chips 201, 202a, 202b, and 203, the following will describe in detail the mounting of the lower semiconductor chip 201 and one 202a among the intermediate semiconductor chips 202a and 202b of the chip stack CS.

The lower semiconductor chip 201 may be connected to the intermediate semiconductor chip 202a. For example, the lower semiconductor chip 201 and the intermediate semiconductor chip 202a may contact each other. At an interface between the lower semiconductor chip 201 and the intermediate semiconductor chip 202a, the second upper pads 240 of the lower semiconductor chip 201 may be bonded to the second lower pads 260 of the intermediate semiconductor chip 202a. For example, the upper signal pads TSP of the lower semiconductor chip 201 may be bonded to the lower signal pads BSP of the intermediate semiconductor chip 202a, and the upper test pads TTP of the lower semiconductor chip 201 may be bonded to the lower test pads BTP of the intermediate semiconductor chip 202a. In this configuration, the second upper and lower pads 240 and 260 may constitute an intermetallic hybrid bonding therebetween.

On the edge region ER, the upper test pads TTP of the lower semiconductor chip 201 may be electrically connected to the lower test pads BTP of the intermediate semiconductor chip 202a. The upper test pads TTP of the lower semiconductor chip 201 may be connected in series to the lower test pads BTP of the intermediate semiconductor chip 202a. The following will describe in detail a connection between the upper test pads TTP of the lower semiconductor chip 201 and the lower test pads BTP of the intermediate semiconductor chip 202a.

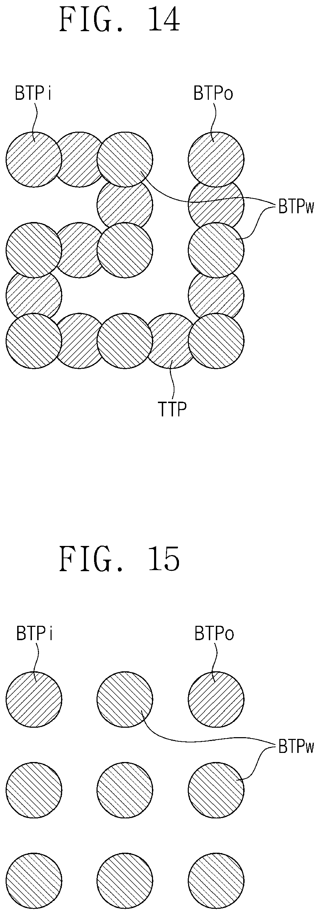

FIGS. 14 to 16 illustrate plan views showing an arrangement and connection relation between test pads.

Referring to FIGS. 13 to 16, when viewed in a plan view, the lower test pads BTP may be arranged in a plurality of rows and columns. When viewed in a plan view, the upper test pads TTP may be arranged in a plurality of rows and columns. For example, the rows and columns of the upper test pads TTP may be different from the rows and columns of the lower test pads BTP, and some gaps may be formed in the row and column pattern of the upper test pads TTP so that the upper test pads TTP appear to be arranged in an irregular pattern that includes pads between the pads of the lower test pads BTP when viewed in a plan view. Also, though the lower test pads BTP are shown as being in rows and columns with upper test pads TTP between them from a plan view, the opposite may be the case, such that the upper test pads TTP are in rows and columns and lower test pads BTP are between them from a plan view. Each of the lower test pads BTP may overlap two neighboring ones of the upper test pads TTP. Each of the upper test pads TTP may overlap two neighboring ones of the lower test pads BTP. Each of the upper test pads TTP may be bonded to the first in-pad BTPi and one of the first connection pads BTPw, two neighboring ones of the first connection pads BTPw, or the first out-pad BTPo and one of the first connection pads BTPw. For example, as shown in FIG. 15, the first in-pad BTPi, the first out-pad BTPo, and the first connection pads BTPw may be arranged in a plurality of rows and columns. As shown in FIGS. 14 to 16, the upper test pads TTP may be positioned and connected to each other between the first in-pad BTPi, the first connection pads BTPw, and the first out-pad BTPo. A series test circuit may be constituted by the first in-pad BTPi, the first connection pads BTPw, the first out-pad BTPo, and the upper test pads TTP therebetween. In the series test circuit, the upper test pads TTP and the lower test pads BTP may be alternately connected to each other. The first in-pad BTPi and the first out-pad BTPo may be opposite ends of the series test circuit.

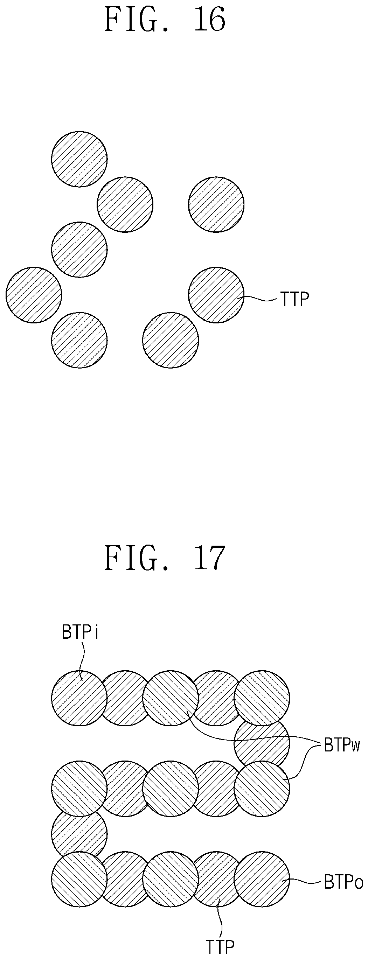

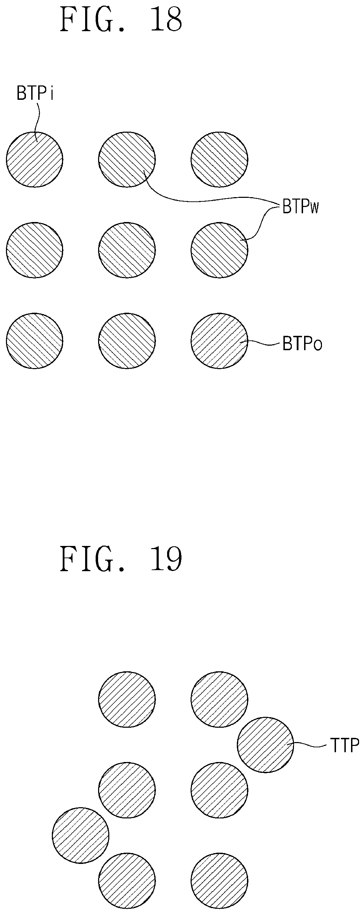

FIGS. 17 to 19 are plan views of an arrangement and connection relation between test pads, showing an embodiment of an arrangement and connection relation between the upper test pads TTP and the lower test pads BTP. When viewed in a plan view as shown in FIGS. 17 to 19, the first in-pad BTPi and the first out-pad BTPo may be positioned on opposite corners in rows and columns of the lower test pads BTP. The first in-pad BTPi, the first connection pads BTPw, the first out-pad BTPo, and the upper test pads TTP therebetween may be connected to form a zigzag shape when viewed in a plan view. An arrangement and connection relation between the lower test pads BTP and the upper test pads TTP shown in FIGS. 14 to 19 are a mere example of some embodiments of the present inventive concepts, and the present inventive concepts are not limited thereto. The arrangement of connection relation between the lower test pads BTP and the upper test pads TTP may include various arrangements and connection relations for a series circuit constituted by the first in-pad BTPi, the first connection pads BTPw, the first out-pad BTPo, and the upper test pads TTP therebetween.

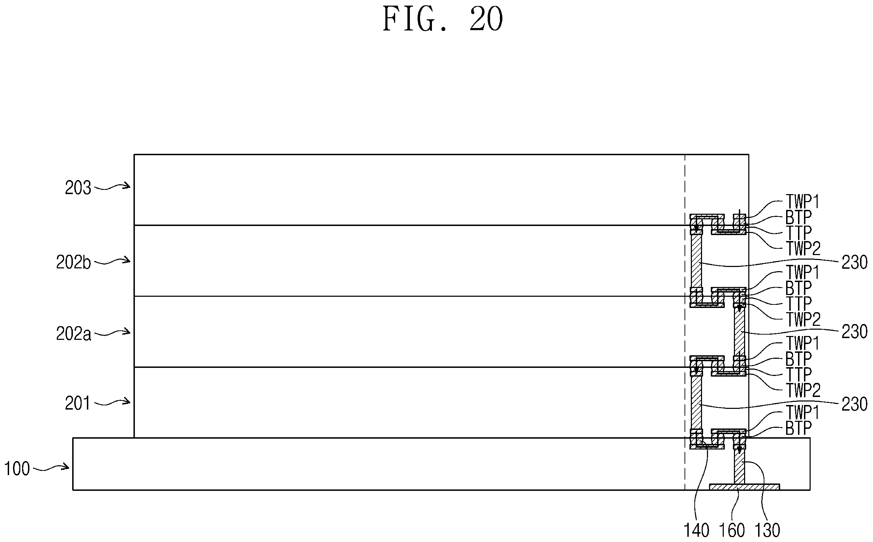

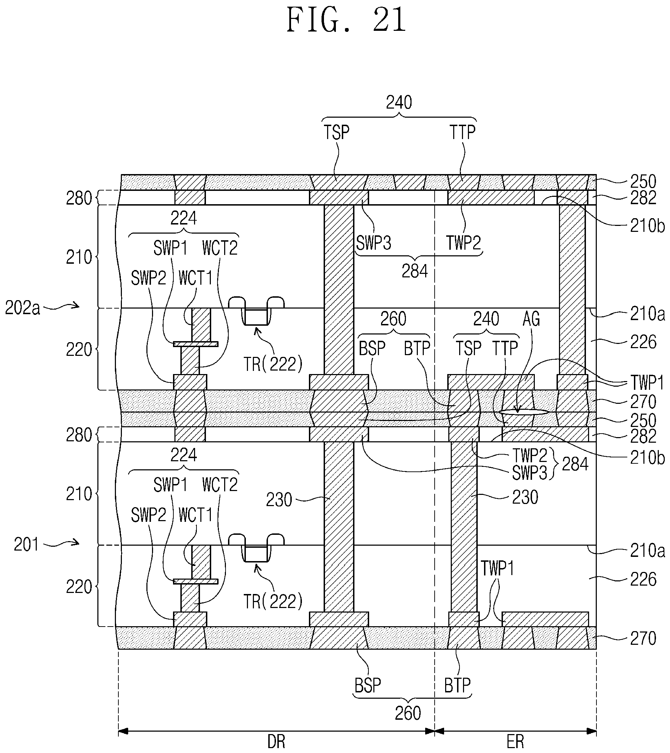

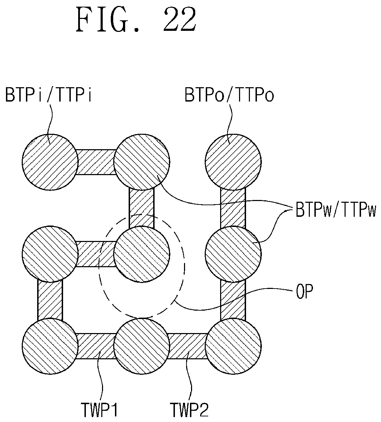

FIGS. 20 to 22 illustrate cross-sectional views showing a method of testing a bonding between semiconductor chips in a semiconductor package according to some embodiments of the present inventive concepts. FIG. 20 corresponds to a cross-sectional view of a semiconductor package. FIG. 21 corresponds to a portion of a cross-sectional view showing a detailed configuration of lower and intermediate semiconductor chips that are bonded to each other. FIG. 22 corresponds to a portion of a plan view showing an arrangement of upper test pads and lower test pads.

Referring to FIG. 20, the lower test pads BTP of the upper semiconductor chip 203, the upper test pads TTP, the second vias 230, and the lower test pads BTP of the intermediate semiconductor chips 202a and 202b, and the upper test pads TTP, the second vias 230, and the lower test pads BTP of the lower semiconductor chip 201 are all connected to each other to form one series circuit, e.g., formed in a daisy chain configuration and which may be described as a test circuit, and the first semiconductor chip 100 may be provided with an electrical signal that flows along arrows illustrated in FIG. 20. The electrical signal provided to the first semiconductor chip 100 may be externally sensed through the first lower pad 160 and an external terminal (not shown) on the first lower pad 160. For example, when the upper test pads TTP and the lower test pads BTP are bonded normally due to no spacing between the semiconductor chips 201, 202a, 202b, and 203, the one series circuit, which comprises the lower test pads BTP of the upper semiconductor chip 203, the upper test pads TTP, the second vias 230, and the lower test pads BTP of the intermediate semiconductor chips 202a and 202b, and the upper test pads TTP, the second vias 230, and the lower test pads BTP of the lower semiconductor chip 201, are not disconnected, the electrical signal may be detected from the first lower pad 160 through the upper test pads TTP, the lower test pads BTP, and the second vias 230.

FIGS. 21 and 22 show an example where a spacing is created between the semiconductor chips 201, 202a, 202b, and 203 of a semiconductor package, for example, between the lower semiconductor chip 201 and the intermediate semiconductor chip 202a. As shown in FIGS. 21 and 22, an air gap AG may be formed between the lower semiconductor chip 201 and the intermediate semiconductor chip 202a. In this case, the air gap AG may cause no bonding between one of the upper test pads TTP in the lower semiconductor chip 201 and one of the lower test pads BTP in the intermediate semiconductor chip 202a. In this case, an open circuit may be generated in a series circuit constituted by the second test wiring pattern TWP2 and the upper test pads TTP of the lower semiconductor chip 201 and the lower test pads BTP and the first test wiring pattern TWP1 of the intermediate semiconductor chip 202a. The electrical signal may not be detected (or may be reduced) from the first lower pad 160.

The lower test pads BTP of the upper semiconductor chip 203, the upper test pads TTP, the second vias 230, and the lower test pads BTP of the intermediate semiconductor chips 202a and 202b, and the upper test pads TTP, the second vias 230, and the lower test pads BTP of the lower semiconductor chip 201 may all be connected to each other to form one series circuit, and structural defects of a semiconductor package may be detected no matter where the air gap AG is formed on any position on the edge region ER or between the semiconductor chips 201, 202a, 202b, and 203, due to differences in the test signal compared to the expected form or strength of the test signal. Note that the air gap AG may include atmospheric air, or other gases, or may be in a vacuum or near vacuum state.

According to some embodiments of the present inventive concepts, a semiconductor package may be configured to inspect the air gap AG whose width is greater than an interval between the upper test pads TTP on the edge region ER or between the lower test pads BTP on the edge region ER. A small air gap AG may be detected in a large region. In addition, one series circuit may be used to detect the air gap AG in a wide area and/or the air gap AG between a plurality of semiconductor chips 201, 202a, 202b, and 203.

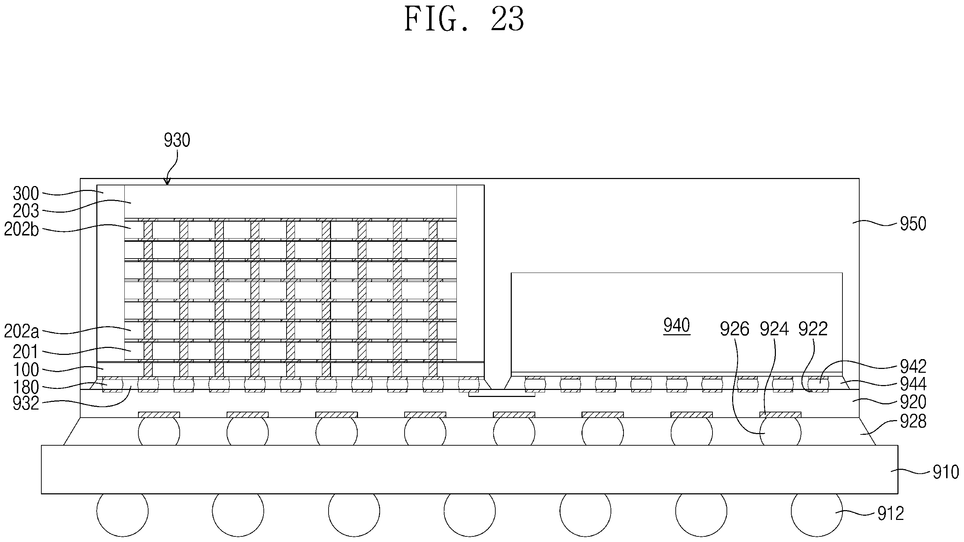

FIG. 23 illustrates a cross-sectional view showing a semiconductor package according to some embodiments of the present inventive concepts.

Referring to FIG. 23, a semiconductor module may be, for example, a memory module including a module substrate 910, a chip stack package 930 and a graphic processing unit (GPU) 940 that are mounted on the module substrate 910, and an outer molding layer 950 that covers the chip stack package 930 and the graphic processing unit 940. The semiconductor module may further include an interposer 920 provided on the module substrate 910.

The module substrate 910 may be provided. The module substrate 910 may include a printed circuit board (PCB) having a signal pattern on a top surface thereof.

The module substrate 910 may be provided with module terminals 912 thereunder. The module substrate 910 may include solder balls or solder bumps, and based on type of the module substrate 910, the semiconductor module may be provided in the shape of one of a ball grid array (BGA) type, a fine ball-grid array (FBGA) type, and a land grid array (LGA) type.

The interposer 920 may be provided on the module substrate 910. The interposer 920 may include first substrate pads 922 exposed on a top surface of the interposer 920 and second substrate pads 924 exposed on a bottom surface of the interposer 920. The interposer 920 may redistribute the chip stack package 930 and the graphic processing unit 940. The interposer 920 may be flip-chip mounted on the module substrate 910. For example, the interposer 920 may be mounted on the module substrate 910 through substrate terminals 926 provided on the second substrate pads 924. The substrate terminals 926 may include solder balls or solder bumps. A first under-fill layer 928 may be provided between the module substrate 910 and the interposer 920.

The chip stack package 930 may be disposed on the interposer 920. The chip stack package 930 may have a structure the same as or similar to that of the semiconductor package discussed with reference to FIGS. 1 to 19.

The chip stack package 930 may be mounted on the interposer 920. For example, the chip stack package 930 may be coupled through the external terminals 180 of the first semiconductor chip 100 to the first substrate pads 922 of the interposer 920. A second under-fill layer 938 may be provided between the chip stack package 930 and the interposer 920. The second under-fill layer 932 may fill a space between the interposer 920 and the first semiconductor chip 100 and may surround the external terminals 180 of the first semiconductor chip 100.

The graphic processing unit 940 may be disposed on the interposer 920. The graphic processing unit 940 may be disposed spaced apart from the chip stack package 930. The graphic processing unit 940 may have a thickness greater than those of the semiconductor chips 100, 201, 202a, 202b, and 203 of the chip stack package 930. The graphic processing unit 940 may include a logic circuit. For example, the graphic processing unit 940 may be a logic chip. The graphic processing unit 940 may be provided with bumps 942 on a bottom surface thereof. For example, the graphic processing unit 940 may be coupled through the bumps 942 to the first substrate pads 922 of the interposer 920. A third under-fill layer 944 may be provided between the interposer 920 and the graphic processing unit 940. The third under-fill layer 944 may surround the bumps 942 while filling a space between the interposer 920 and the graphic processing unit 940.

The outer molding layer 950 may be provided on the interposer 920. The outer molding layer 950 may cover the top surface of the interposer 920. The outer molding layer 950 may encapsulate the chip stack package 930 and the graphic processing unit 940. The outer molding layer 950 may have a top surface located at the same level as that of a top surface of the chip stack package 930. The outer molding layer 950 may include a dielectric material. For example, the outer molding layer 950 may include an epoxy molding compound (EMC). Because the outer molding layer 950 may encapsulate the entire device, the semiconductor module of FIG. 23 may be a memory package.

A semiconductor package according to some embodiments of the present inventive concepts may be configured to easily test structural defects such as spacing between semiconductor chips on an edge region. According to various embodiments herein a void, gap, or warpage, can be detected in different horizontal directions because rows and columns of test pads may be used. A small-sized air gap may be detected in a wide area, for example covered by the rows and columns of test pads, and one series circuit or wiring pattern may be used to detect an air gap in a region whose area is large and/or an air gap between a plurality of semiconductor chips. In addition, because lower test pads, the upper test pads, and vias of the semiconductor chips are all connected to form one series circuit or wiring pattern, it may be possible to accomplish a simplified test circuit for detecting defects even on a wide area.

Although the present inventive concepts have been described in connection with some embodiments of the present inventive concepts illustrated in the accompanying drawings, it will be understood by one of ordinary skill in the art that variations in form and detail may be made therein without departing from the essential features of the present inventive concepts. The above disclosed embodiments should thus be considered illustrative and not restrictive.

## Claims

1. A semiconductor package, comprising:
a substrate;
a first semiconductor chip on the substrate, the first semiconductor chip including a first semiconductor substrate and a first test pattern on a first surface of the first semiconductor substrate; and
a second semiconductor chip on the first semiconductor chip, the second semiconductor chip including a second semiconductor substrate and a second test pattern on a second surface of the second semiconductor substrate,
wherein the second semiconductor chip and the first semiconductor chip are bonded to each other to allow the first test pattern to face the second test pattern,
wherein the first test pattern includes a first in-pad, first connection pads, and a first out-pad that are arranged in a plurality of rows and columns,
wherein the second test pattern includes a second in-pad bonded to the first in-pad, a second out-pad bonded to the first out-pad, and second connection pads bonded to the first connection pads, and
wherein the first connection pads and the second connection pads are connected in series to alternately connect with each other and form a series wiring pattern, so that each first connection pad connects to another first connection pad in one direction along the series wiring pattern and to a second connection pad in an opposite direction along the series wiring pattern.

2. The semiconductor package of claim 1, wherein:
each of the first connection pads is vertically aligned with and bonded to one of the second connection pads,
the first test pattern further includes first wiring patterns that connect two neighboring ones of the first connection pads to each other, and
the second test pattern further includes second wiring patterns that connect two neighboring ones of the second in-pad, the second connection pads, and the second out-pad to each other.

3. The semiconductor package of claim 1, wherein each of the first connection pads is disposed to simultaneously overlap two neighboring ones of the second connection pads, the each of the first connection pads being bonded to the two neighboring ones of the second connection pads.

4. The semiconductor package of any preceding claim, wherein:
the second in-pad is electrically connected to one of the second connection pads, and
the second out-pad is electrically connected to another one of the second connection pads.

5. The semiconductor package of any preceding claim, wherein each of the first and second connection pads has a circular planar shape, a tetragonal planar shape, or polygonal planar shape.

6. The semiconductor package of any preceding claim, wherein:
on the first surface of the first semiconductor substrate, the first test pattern is adjacent to a corner of the first semiconductor substrate, and
on the second surface of the second semiconductor substrate, the second test pattern is adjacent to a corner of the second semiconductor substrate.

7. The semiconductor package of any preceding claim, wherein:
each of the second in-pad, the second connection pads, and the second out-pad has a width of about 2 µm to about 50 µm, and
each of the second in-pad, the second connection pads, and the second out-pad has a width of about 2 µm to about 50 µm.

8. The semiconductor package of any preceding claim, wherein:
the first semiconductor chip further includes a first through via that vertically penetrates the first semiconductor substrate, the first through via being connected to the first out-pad, and
the second semiconductor chip further includes a second through via that vertically penetrates the second semiconductor substrate, the second through via being connected to the second in-pad.

9. The semiconductor package of any preceding claim, wherein:
the first semiconductor chip further includes a first semiconductor element at a bottom surface of the first semiconductor substrate, the first test pattern being electrically insulated from the first semiconductor element, and
the second semiconductor chip further includes a second semiconductor element at the second surface of the second semiconductor substrate, the second test pattern being electrically insulated from the second semiconductor element.

10. The semiconductor package of any preceding claim, further comprising a third semiconductor chip on the second semiconductor chip,
wherein the second semiconductor chip further includes a third test pattern on a top first surface of the second semiconductor substrate,
wherein the third semiconductor chip includes a third semiconductor substrate and a fourth test pattern on a bottom surface of the third semiconductor substrate,
wherein the third test pattern includes a third in-pad, third connection pads, and a third out-pad that are arranged in a plurality of rows and columns,
wherein the fourth test pattern includes a fourth in-pad bonded to the third in-pad, a fourth out-pad bonded to the third out-pad, and fourth connection pads bonded to the third connection pads, and
wherein the third connection pads and the fourth connection pads are connected in series to alternately connect with each other.

11. The semiconductor package of claim 10, wherein the second semiconductor chip further includes a second through via that vertically penetrates the second semiconductor substrate,
wherein the second through via is connected to the second in-pad and the third out-pad.

12. The semiconductor package of any preceding claim, wherein:
the first in-pad and the second in-pad are bonded to each other, the first in-pad and the second in-pad constituting a single unitary piece formed of the same material,
the first out-pad and the second out-pad are bonded to each other, the first out-pad and the second out-pad constituting a single unitary piece formed of the same material, and
the first connection pads and the second connection pads are bonded to each other, each first connection pad and corresponding second connection pad constituting a single unitary piece formed of the same material.

13. The semiconductor package of any preceding claim, wherein
the first surface of the first semiconductor chip is flat and coplanar with a top surface of the first test pattern, and
the second surface of the second semiconductor chip is flat and coplanar with a bottom surface of the second test pattern.
